# EUROPÄISCHE PATENTANMELDUNG

(11) **EP 1 312 785 A2**
(43) Veröffentlichungstag der Anmeldung: **21.05.2003**
(21) Anmeldenummer: 02021150.4
(22) Anmeldetag: 24.09.2002
(51) Int. Cl.: F02D 41/20, F02M 51/06, F02M 59/46

(54) **Schaltungsanordnung zum Laden und Entladen von piezoelektrischen Elementen sowie zur Abschaltung einer Piezo-Endstufe**

(30) Priorität: 10.11.2001 DE 10155388
(71) Anmelder: ROBERT BOSCH GMBH, 70442 Stuttgart (DE)
(72) Erfinder: Reineke, Joerg, 71254 Ditzingen (DE)

(57) **Zusammenfassung**

Die Erfindung betrifft eine Schaltungsanordnung zum Laden und Entladen von piezoelektrischen Elementen, die von einer Piezo-Endstufe ansteuerbar sind.

Die Schaltungsanordnung sieht eine redundante Reset-Schaltung (14) vor, mittels der die Piezo-Endstufe (16) abschaltbar ist und die piezoelektrischen Elemente (Pxxx) entladbar und nicht wiederaufladbar schaltbar sind.

## Beschreibung

Die Erfindung betrifft eine Schaltungsanordnung zum Laden und Entladen piezoelektrischer Elemente sowie zur Abschaltung einer Piezo-Endstufe gemäß dem Oberbegriff des Anspruchs 1 genannten Merkmalen.

### Stand der Technik

Es ist bekannt, dass zur Motorsteuerung von Kraftfahrzeugen Steuergeräte zur Ansteuerung von Einspritzsystemen eingesetzt werden. Diese Steuergeräte sorgen für die exakte Steuerung beziehungsweise Regelung von Einspritzmenge und Einspritzzeitpunkt innerhalb eines Verbrennungsmotors. Einspritzsysteme von Kraftfahrzeugen arbeiten mit einem Einspritzdüsen umfassenden System. Die Einspritzdüsen werden von piezoelektrischen Elementen angesteuert. Das Steuergerät besteht im Wesentlichen aus einem Endstufenbaustein, einer Hochspannungsversorgung, einem Gleichspannungswandler, einem Bufferkondensator und einer Piezo-Endstufe. Vorhandene Leistungsschalter der Piezo-Endstufe werden zum Laden der piezoelektrischen Elemente über den Endstufenbaustein angesteuert.

Beim Fehlerfall eines dieser Bausteine der Piezo-Endstufe ist es nicht möglich, die Endstufe abzuschalten und somit in einen sicheren - Reset-Zustand - zu bringen. Es besteht hierbei die Möglichkeit, dass an den piezoelektrischen Elementen noch Spannung anliegt, obwohl ein Fehler der Piezo-Endstufe vorliegt.

### Vorteile der Erfindung

Durch eine Schaltungsanordnung mit den im Anspruch 1 genannten Merkmalen ist vorteilhaft möglich, redundante Abschaltpfade bei Piezo-Endstufen zu schaffen. Dadurch, dass eine redundante Reset-Schaltung vorgesehen ist, mittels der die Piezo-Endstufe abschaltbar ist und die piezoelektrischen Elemente in einen Schaltzustand bringbar sind, in dem diese entladbar und nicht wiederaufladbar sind, wird verhindert, dass in einem Fehlerfall die piezoelektrischen Elemente aktiv bleiben. Insbesondere wird erreicht, dass die piezoelektrischen Elemente entladen werden, so dass diese im Fehlerfall keine weiteren drehmomentbildenden Einspritzungen von Kraftstoff gestatten.

In bevorzugter Ausgestaltung der Erfindung ist vorgesehen, dass die redundante Reset-Schaltung über Schaltpfade bildende Ausgänge zusätzlich mit den die piezoelektrischen Elemente ansteuernden Schaltelementen verbunden ist. Hierdurch wird mit einfachen schaltungstechnischen Maßnahmen eine redundante Ansteuerung der Piezo-Endstufe beziehungsweise der piezoelektrischen Elemente möglich.

In weiterer bevorzugter Ausgestaltung der Erfindung ist vorgesehen, dass die redundante Reset-Schaltung durch ein externes Abschaltsignal aktivierbar ist. Insbesondere wenn in bevorzugter Ausgestaltung die Reset-Schaltung durch ein low aktives externes Abschaltsignal aktivierbar ist, kann so durch eine beispielsweise im Fehlerfall hervorgerufene Spannungsunterbrechung oder dergleichen bei der Ansteuerung der Piezo-Endstufe die Reset-Schaltung in einfacher Weise aktiviert werden.

Da die redundante Reset-Schaltung unabhängig von der eigentlichen Ansteuerschaltung der Piezo-Endstufe aufgebaut ist und aktivierbar ist, wird ein Einfluss auf die Funktion der Piezo-Endstufe in deren bestimmungsgemäßen Gebrauch nicht möglich.

Weitere bevorzugte Ausgestaltungen der Erfindung ergeben sich aus den übrigen, in den Unteransprüchen genannten Merkmalen.

### Zeichnungen

Die Erfindung wird nachfolgend in einem Ausführungsbeispiel anhand der zugehörigen Zeichnungen näher erläutert. Es zeigen:
- Figur 1: eine Schaltungsanordnung einer Piezo-Endstufe mit übergeordneter redundanter Reset-Schaltung und
- Figur 2: eine Detail-Schaltungsanordnung der redundanten, übergeordneten Reset-Schaltung.

### Beschreibung des Ausführungsbeispiels

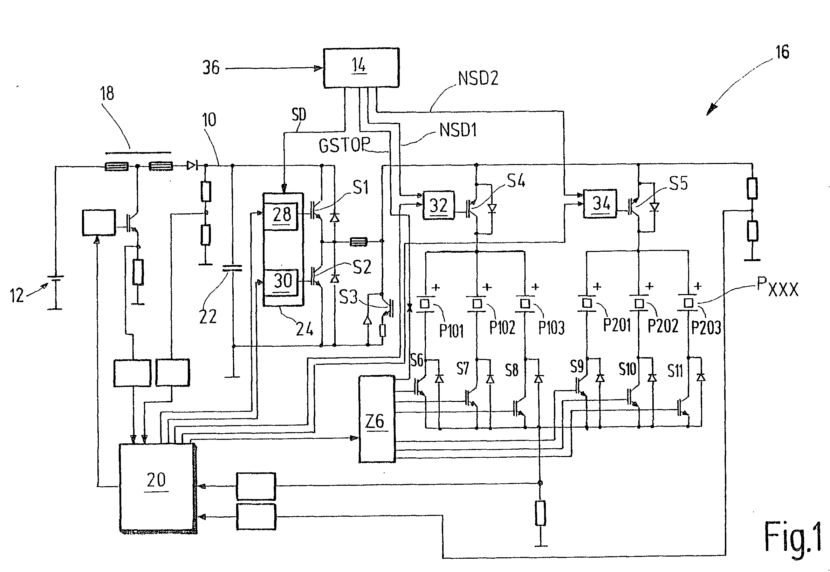

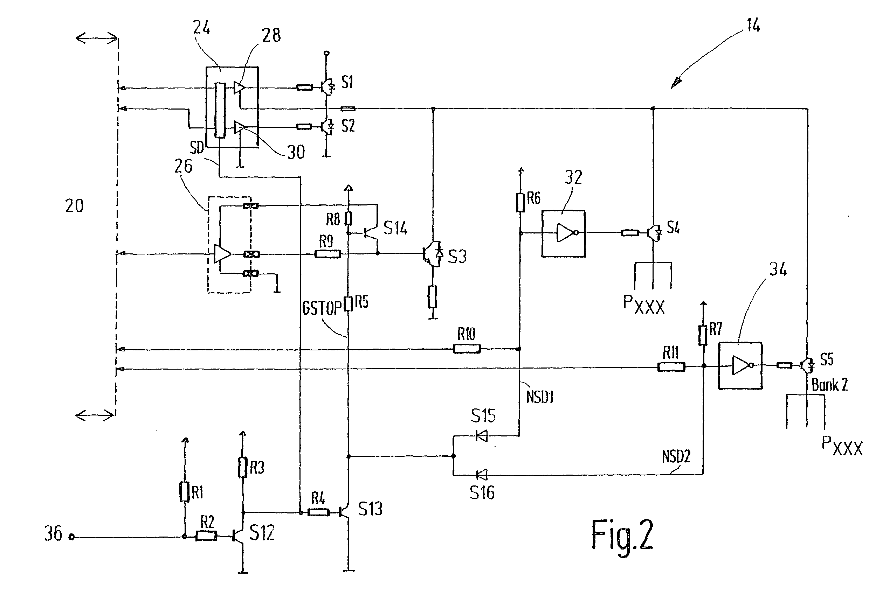

In den Figuren 1 und 2 sind die schaltungsrelevanten Bauteile dargestellt und bezeichnet, die zur Erläuterung der Erfindung notwendig sind. Die Schaltungsanordnung gemäß Figur 1 zeigt eine Piezo-Endstufe 16. Die Piezo-Endstufe 16 besitzt im Wesentlichen eine Gleichspannungsversorgung 12, beispielsweise eine Kraftfahrzeugbatterie, und einen Gleichspannungswandler 18. Der Gleichspannungswandler 18 stellt eine Spannung 10 bereit, mit der ein Bufferkondensator 22 gespeist wird.

Parallel zum Bufferkondensator 22 ist ein Halbbrückentreiber 24 geschaltet. Der Halbbrückentreiber 24 umfasst einen Treiber 28 und einen Treiber 30. Dem Treiber 28 ist ein Schaltelement S1 und dem Treiber 30 ein Schaltelement S2 zugeordnet. Der Bufferkondensator 22 ist parallel zur Reihenschaltung der Schaltelemente S1 und S2 geschaltet.

Ein Schaltelement S3 ist mit Masse einerseits und mit Schaltelementen S4 und S5 andererseits verbunden. Die Schaltelemente S4 und S5 sind über jeweils einen invertierenden Treiber 32 und 34 ansteuerbar.

Das Schaltelement S4 ist mit piezoelektrischen Elementen P101, P102 und P103 verbunden. Das Schaltelement S5 ist mit piezoelektrischen Elementen P201, P202 und P203 verbunden.

Die piezoelektrischen Elemente P101, P102 und P103 sind ausgangsseitig mit Schaltelementen S6, S7 und S8 verbunden. Die piezoelektrischen Elemente P201, P202 und P203 sind ausgangsseitig mit Schaltelementen S9, S10 und S11 verbunden.

Die Schaltelemente S1, S2, S4 und S5 sind über die Treiber 24, 32, 34 von einem Endstufenbaustein 20 ansteuerbar.

Die Schaltelemente S6, S7, S8, S9, S10 und S11 sowie das Schaltelement S3 sind über einen weiteren Treiber 26 vom Endstufenbaustein 20 ansteuerbar.

Die Schaltungsanordnung zeigt folgende grundlegende Funktion: Beispielsweise bei einem Einspritzsystem einer Motorsteuerung eines Kraftfahrzeuges werden die Aktoren - also die piezoelektrischen Elemente Pxxx - auf so genannte Bänke aufgeteilt.

Eine erste Bank umfasst die piezoelektrischen Elemente P101, P102 und P103. Eine zweite Bank umfasst die piezoelektrischen Elemente P201, P202 und P203.

Durch die Schaltelemente S4 und S5 - den Bank-Auswahlschaltern - wird die Bank angesteuert, die geladen oder entladen werden soll. Durch Ansteuern (Schließen) der Schaltelemente S6, S7, S8, S9, S10 und/oder S11 wird die Auswahl der piezoelektrischen Elemente Pxxx innerhalb der Bänke vorgenommen, die geladen oder entladen werden sollen.

Durch die Schaltelemente S1 - Ladeschalter - und S2 - Entladeschalter - werden über die Schaltelemente S4 und S5 die piezoelektrischen Elemente Pxxx - entsprechend der Schaltstellung der Schaltelemente S4 bis S11 - entweder aufgeladen oder entladen. Dazu steht als Energiequelle der Bufferkondensator 22 zur Verfügung, der wiederum aus dem Gleichspannungswandler 18 mit der Spannung 10 versorgt wird. Für die Versorgungsspannung der Piezo-Endstufe 16 sorgt die Gleichspannungsquelle 12.

Das Schaltelement S3 - Notentladeschalter - dient zur sicheren und vollständigen Entladung der piezoelektrischen Elemente P101-P103 beziehungsweise P201-203, indem diese bei angesteuertem Schaltelement S3 über die Schaltmittel S4 beziehungsweise S5 mit Masse verbunden werden.

Der bisher beschriebenen Schaltungsanordnung ist eine redundante Reset-Schaltung 14 zugeordnet. Die Reset-Schaltung 14 besitzt Ausgänge SD, GSTOP, NSD1 und NSD2.

Der Ausgang SD ver- oder entriegelt den Halbbrückentreiber 24. Über GSTOP ist das Schaltelement S3 schaltbar. Mittels NSD1 und NSD2 sind über den invertierenden Treiber 32 beziehungsweise den invertierenden Treiber 34 das Schaltelement S4 beziehungsweise das Schaltelement S5 ansteuerbar.

Der detaillierte Aufbau der Reset-Schaltung 14 ist aus Figur 2 ersichtlich. Bei der nachfolgenden Erläuterung wird davon ausgegangen, dass es sich bei den Schaltelementen um Transistoren handelt.

Ein Schaltelement S12 ist basisseitig mit Widerständen R1 und R2 und emitterseitig mit Masse verbunden. Der Kollektor ist mit einem Widerstand R3 verbunden. Der Kollektor ist ebenfalls über den Ausgang SD mit dem Halbbrückentreiber 24 verbunden.

Zum Schaltelement S12 ist ein Schaltelement S13 parallel geschaltet, dessen Basis über einen Widerstand R4 mit dem Kollektor des Schaltelementes S12 und dem Ausgang SD verbunden ist. Ein Emitter des Schaltelementes S13 ist auf Masse geführt.

Der Kollektor des Schaltelementes S13 ist mit dem Ausgang GSTOP verbunden. Der Ausgang GSTOP steuert ein Schaltelement S14 an, das wiederum das Schaltelement S3 ansteuert.

Das Schaltelement S3 ist darüber hinaus über den Treiber 26 und einen Widerstand R9 vom Endstufenbaustein 20 direkt ansteuerbar.

Der Kollektor des Schaltelementes S13 ist zudem mit den Ausgängen NSD1 und NSD2 verbunden. In den sich hierzu verzweigenden Abgängen ist einerseits eine Diode S15 und andererseits eine Diode S16 geschaltet.

Die Diode S15 ist kathodenseitig mit dem Endstufenbaustein 20 über einen Widertand R10 und dem invertierenden Treiber 32 verbunden. Über die Diode S15 ist bei angesteuertem Schaltelement S13 das Schaltelement S4 über den invertierenden Treiber 32 schaltbar.

Die Diode S16 ist kathodenseitig mit dem Endstufenbaustein 20 über einen Widertand R11 und dem Treiber 34 verbunden. Über die Diode S16 ist bei angesteuertem Schaltelement S13 das Schaltelement S5 über den invertierenden Treiber 34 schaltbar.

Die Funktionsweise der Schaltungsanordnung gemäß den Figuren 1 und 2 wird nachfolgend erläutert.

Die Schaltelemente Sxx sind npn- oder pnp-schaltende Bipolartransistoren. Die npn-Bipolartransistoren sind beim Anlegen einer Basis-Emitter-Spannung durchgesteuert, das heißt eingeschaltet. Pnp-Bipolartransistoren sind beim Anlegen der Basis-Emitterspannung nicht durchgesteuert, das heißt ausgeschaltet.

Sollen beispielweise die piezoelektrischen Elemente P101 und P201 geladen werden, so werden die Schaltelemente S1, S4, S5, S6 und S9 geschlossen und Ladungsträger fließen vom Bufferkondensator 22 auf die piezoelektrischen Elemente P101 und P201. Sollen die piezoelektrischen Elemente P101 und P201 entladen werden, so werden die Schaltelemente S2, S4, S5, S6 und S9 geschlossen und die piezoelektrischen Elemente P101 und P201 liegen an Masse. Dieser Vorgang ist für alle dargestellten piezoelektrischen Elemente Pxxx gleichermaßen durchführbar.

Eine Notentladung erfolgt über das Schließen der Schaltelemente S3, S4 und S5, wodurch die piezoelektrischen Elemente P101 und P201 notentladen werden. Diese Notentladung kann gleichermaßen mit den weiteren dargestellten piezoelektrischen Elementen Pxxx durchgeführt werden.

Diese bisher beschriebene Funktion der Schaltungsanordnung und der stationäre Zustand, bei der mindestens ein piezoelektrisches Element Pxxx geladen ist, stellt die Ausgangsposition für die weitere Beschreibung dar.

Beispielweise sind die piezoelektrischen Elemente P101 und P201 - wie zuvor beschrieben - geladen.

Die Reset-Schaltung 14 wird nicht wirksam, wenn ein externes Abschaltsignal 36 auf dem Potential high liegt. Liegt das Abschaltsignal 36 auf dem Potential low, ist die Reset-Schaltung 14 aktiviert.

Im fehlerfreien Zustand befindet sich das externe Abschaltsignal 36 durch den Widerstand R1 auf Potential high. Der npn-leitende Transistor S12 wird durchgesteuert. Das Kollektorausgangssignal des Transistors S12 ist auf low, da der Emitterausgang auf Masse geführt ist. Damit ist das Signal SD auf low und der Halbbrückentreiber 30 arbeitet in Abhängigkeit von den Ansteuersignalen des Endstufenbausteins 20.

Durch das Signal low des Transistors S12 ist der Transistor S13, ebenfalls als npn-Transistor ausgeführt, nicht durchgesteuert. Die Eingangsignale der invertierenden Treiber 32 und 34 für die beiden Bankauswahlschalter S4 und S5 sind durch die Widerstände R6 beziehungsweise R7 auf Potential high. Durch die invertierende Funktion der Treiber 32 und 34 können die Bankauswahlschalter S4 und S5 in diesem Schaltzustand allein vom Endstufenbaustein 20 angesteuert werden.

Durch die Dioden S15 und S16 ist sichergestellt, dass bei Ansteuerung der invertierenden Treiber 32 und 34 durch den Endstufenbaustein 20 ein schaltaktives Massepotential des Endstufenbausteins 20 nicht auf den Kollektorausgang von Transistor S13 wirkt und somit die Schaltfunktionen der Transistoren S14 und S3 beeinflusst.

Dadurch, dass der Transistor S13 nicht durchgesteuert ist und der Kollektorausgang von Transistor S13 Potential high angenommen hat, ist auch der Transistor S14 - als pnp-leitender Transistor ausgeführt - nicht durchgesteuert. Der Notentladeschalter S3 ist über den Widerstand R9 alleine vom Endstufenbaustein 20 über den Treiber 26 ansteuerbar.

In diesem Schaltzustand ist die Piezo-Endstufe 16 im Normalbetrieb, die Reset-Schaltung 14 ist unwirksam und die piezoelektrischen Elemente P101 und P102 bleiben geladen.

Im Fehlerfall wird das externe Abschaltsignal 36 auf low geschaltet. Über den zur Arbeitspunkteinstellung dienenden Widerstand R2 erhält der Transistor S12 eine nicht schaltende Spannung low, das heißt, er wird nicht durchgesteuert. Dadurch wird das Signal am Ausgang SD durch den Widerstand R3 high und verriegelt den Halbbrückentreiber 30 und sperrt dessen Funktion. Eine Ansteuerung der Schaltelemente S1, dem Ladeschalter, und dem Schaltelement S2, dem Entladeschalter, ist aus Richtung des Endstufenbausteins 20 nicht mehr möglich.

Dadurch, dass der Transistor S12 nicht durchgesteuert ist, wird das Potential an der Basis des Transistors S13 high. Der Transistor S13 wird durchgesteuert. Das kollektorseitige Ausgangssignal von Transistor S13 nimmt Potential low an.

Daraus folgend nimmt Transistor S14 an seiner Basis das Potential low an. Der Transistor S14, da er als pnp-schaltender Transistor ausgeführt wird, wird durchgesteuert. Über den Transistor S14 wird hierdurch das Schaltelement S3, der Notentladeschalter, direkt aus der Reset-Schaltung 14 eingeschaltet.

Das kollektorseitige Ausgangssignal low des Transistors S13 wird über die Dioden S15 und S16 durchgelassen. Die Schaltelemente S4 und S5 schließen aufgrund der invertierenden Funktion der Treiber 32 und 34.

Damit sind die Bankauswahlschalter S4 und S5 geschlossen und parallel dazu ist S3 ebenfalls geschlossen.

Ein geschlossener Stromkreis entsteht einerseits über die Bankauswahlschalter S4 und S5 über S3 zum Massepotential des Bufferkondensators 22 und andererseits über die Paralleldioden der Schaltelemente S6 bis S11.

Eine Wiederaufladung der piezoelektrischen Elemente P101 und P201 ist durch den verriegelten Schalter S1 nicht mehr möglich.

Die Piezo-Endstufe 16 ist komplett abgeschaltet und eine Ansteuerung über den Endstufenbaustein 20 ist nicht mehr möglich.

Die Widerstände R9, R10 und R11 dienen der Auslegung der Ansteuersignale vom Endstufenbaustein 20.

## Patentansprüche

1. Schaltungsanordnung zum Laden und Entladen von piezoelektrischen Elementen, die von einer Piezo-Endstufe ansteuerbar sind, **gekennzeichnet durch** eine redundante Reset-Schaltung (14), mittels der die Piezo-Endstufe (16) abschaltbar ist und die piezoelektrischen Elemente (Pxxx) entladbar und nicht wiederaufladbar schaltbar sind.

2. Schaltungsanordnung nach Anspruch 1, **dadurch gekennzeichnet, dass** die Piezo-Endstufe (16) von einer Gleichspannungsversorgung (12) über einen Gleichspannungswandler (18) mit einer Spannung (10) versorgbar ist.

3. Schaltungsanordnung nach einem der vorhergehenden Ansprüche, **dadurch gekennzeichnet, dass** parallel zum Bufferkondensator (22) ein Halbbrückentreiber (24) geschaltet ist, der Schaltelemente (S1, S2) umfasst, mittels denen die piezoelektrischen Elemente (Pxxx) ladbar beziehungsweise entladbar sind.

4. Schaltungsanordnung nach einem der vorhergehenden Ansprüche, **dadurch gekennzeichnet, dass** ein Schaltelement (S4) und ein Schaltelement (S5) angeordnet sind, die jeweils mit den Schaltelementen (S1, S2) zum Laden/Entladen verbunden sind und die jeweils über invertierende Treiber (32) und (34) ansteuerbar sind.

5. Schaltungsanordnung nach Anspruch 4, **dadurch gekennzeichnet, dass** dem Schaltelement (S4) eine erste Bank von verzweigten piezoelektrischen Elementen (P101), (P102) und (P103) zugeordnet ist.

6. Schaltungsanordnung nach Anspruch 4, **dadurch gekennzeichnet, dass** dem Schaltelement (S5) eine zweite Bank von verzweigten piezoelektrischen Elementen (P201), (P202) und (P203) zugeordnet ist.

7. Schaltungsanordnung nach einem der vorhergehenden Ansprüche, **dadurch gekennzeichnet, dass** die Schaltelemente (S4) und (S5) über ein Schaltelement (S3) mit Masse verbunden sind.

8. Schaltungsanordnung nach einem der vorhergehenden Ansprüche, **dadurch gekennzeichnet, dass** die Schaltelemente (S1 bis S5) von einem Endstufenbaustein (20) ansteuerbar sind.

9. Schaltungsanordnung nach einem der vorhergehenden Ansprüche, **dadurch gekennzeichnet, dass** die redundante Reset-Schaltung (14) über einen Ausgang (SD) mit dem Halbbrückentreiber (24) verbunden ist, über den der Halbbrückentreiber (24) verriegelbar ist.

10. Schaltungsanordnung nach einem der vorhergehenden Ansprüche, **dadurch gekennzeichnet, dass** die redundante Reset-Schaltung (14) über einen Ausgang (GSTOP) mit dem Schaltelement (S3) verbunden ist, über den das Schaltelement (S3) schaltbar ist.

11. Schaltungsanordnung nach einem der vorhergehenden Ansprüche, **dadurch gekennzeichnet, dass** die redundante Reset-Schaltung (14) über einen Ausgang (NSD1) mit dem invertierenden Treiber (32) verbunden ist, über den das Schaltelement (S4) schaltbar ist.

12. Schaltungsanordnung nach einem der vorhergehenden Ansprüche, **dadurch gekennzeichnet, dass** die redundante Reset-Schaltung (14) über einen Ausgang (NSD2) mit dem invertierenden Treiber (34) verbunden ist, über den das Schaltelement (S5) schaltbar ist.

13. Schaltungsanordnung nach einem der vorhergehenden Ansprüche, **dadurch gekennzeichnet, dass** ein externes Abschaltsignal (36) die redundante Reset-Schaltung (14) aktiviert.

14. Schaltungsanordnung nach Anspruch 13, **dadurch gekennzeichnet, dass** die Reset-Schaltung (14) low aktiv ist.

15. Schaltungsanordnung nach einem der vorhergehenden Ansprüche, **dadurch gekennzeichnet, dass** die Reset-Schaltung (14) Schaltelemente (S12, S13, S14) umfasst, die durch das Ansteuersignal (36) in ihrem Schaltzustand beeinflussbar sind, und die die Signale an die Ausgänge (SD, GSTOP, NSD1, NSD2) generieren.

16. Schaltungsanordnung nach einem der vorhergehenden Ansprüche, **dadurch gekennzeichnet, dass** die Schaltelemente (Sxx) npn-Bipolartransistoren oder pnp-Bipolartransistoren sind.
